(19) Europäisches Patentamt
European Patent Office
Office européen des brevets

(11) **EP 2 685 458 B1**

(12) **FASCICULE DE BREVET EUROPEEN**

(45) Date de publication et mention
de la délivrance du brevet:
**19.10.2016   Bulletin 2016/42**

(51) Int Cl.:
***G11C 11/16*** *(2006.01)*

(21) Numéro de dépôt: **13175949.0**

(22) Date de dépôt: **10.07.2013**

(54) **Dispositif magnétique à écriture assistée thermiquement**

Magnetvorrichtung zum wärmeunterstützten Schreiben

Magnetic device with thermally assisted writing

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.07.2012   FR 1256670**

(43) Date de publication de la demande:
**15.01.2014   Bulletin 2014/03**

(73) Titulaire: **COMMISSARIAT A L'ENERGIE
ATOMIQUE ET AUX
ENERGIES ALTERNATIVES
75015 Paris (FR)**

(72) Inventeurs:
• **Dieny, Bernard**
  **38250 Lans en Vercors (FR)**
• **Sousa, Ricardo**
  **38000 Grenoble (FR)**

(74) Mandataire: **Lebkiri, Alexandre
Cabinet Camus Lebkiri
25, Rue de Maubeuge
75009 Paris (FR)**

(56) Documents cités:
**EP-A1- 2 447 948      US-A1- 2005 180 202**

## Description

La présente invention concerne un dispositif magnétique à écriture assistée thermiquement de type mémoire MRAM (Magnetic Random Access Memory ou mémoire magnétique à accès direct) ou élément logique (« Magnetic Logic Unit ») à base d'éléments magnétiques magnétorésistifs et à écriture assistée thermiquement.

Les mémoires magnétiques MRAM ont connu un regain d'intérêt avec la mise au point de jonction tunnel magnétique (MTJ ou « Magnetic Tunnel Junction ») présentant une forte magnétorésistance à température ambiante. Les mémoires MRAM comportent plusieurs points mémoires. Ces points mémoires sont généralement des dispositifs magnétiques qui comportent généralement un empilement incluant :

- une couche magnétique appelée « couche de référence » qui présente une aimantation dont la direction est fixe ;
- une couche magnétique appelée « couche de stockage » qui présente une aimantation dont la direction est variable et qui peut s'orienter soit parallèlement, soit antiparallèlement à la direction d'aimantation de la couche de référence ;
- un espaceur réalisé dans un matériau électriquement isolant ou semiconducteur qui sépare la couche de référence et la couche de stockage.

Le document FR2817999 décrit par exemple un tel dispositif magnétique. Ce dispositif magnétique présente deux modes de fonctionnement : un mode « lecture » et un mode « écriture ». Lors du mode écriture, un courant d'électrons ou un champ magnétique est envoyé à travers les couches, de façon à provoquer le retournement de la direction d'aimantation de la couche de stockage, qui devient alors parallèle ou antiparallèle à la direction d'aimantation de la couche de référence. Suivant que la direction d'aimantation de la couche de stockage est parallèle ou antiparallèle à la direction d'aimantation de la couche de référence, un « 1 » ou un « 0 » est stocké dans la couche de stockage.

Lors du mode lecture, un courant d'électrons est injecté à travers le dispositif magnétique de façon à lire sa résistance. Lorsque les directions d'aimantation de la couche de référence et de la couche de stockage sont parallèles, la résistance de la jonction est faible, tandis que lorsque les directions d'aimantation des couches de référence et de stockage sont antiparallèles, la résistance de la jonction est élevée. Par comparaison avec une résistance de référence, la valeur stockée dans la couche de stockage (« 0 » ou « 1 ») peut être déterminée.

Le document FR2924851 propose par ailleurs d'ajouter au dispositif décrit précédemment une couche antiferromagnétique au contact de la couche de stockage. Hors mode écriture et en particulier en mode lecture, cette couche antiferromagnétique permet de figer la direction d'aimantation de la couche de stockage afin que l'information stockée dans la couche de stockage ne varie pas. En mode écriture par contre, la couche antiferromagnétique est chauffée de façon à ce qu'elle devienne paramagnétique ou tout au moins que sa température excède la température dite de blocage de la couche antiferromagnétique. Cette température de blocage est en générale inférieure à la température de Néel du matériau antiferromagnétique mais elle se rapproche de plus en plus de la température de Néel au fur et à mesure que la durée du chauffage diminue vers des durées de l'ordre de quelques nanosecondes. La température de Néel du matériau antiferromagnétique est la température à laquelle l'ordre antiferromagnétique disparait et au dessus de laquelle le matériau se comporte comme un paramagnétique. Lorsque la température de la couche antiferromagnétique dépasse la température de blocage, la direction d'aimantation de la couche de stockage peut alors être modifiée puisqu'elle n'est plus piégée par la couche antiferromagnétique. Une fois que l'on a modifié la direction d'aimantation de la couche de stockage, le chauffage de la couche antiferromagnétique est arrêté. La couche antiferromagnétique redevient alors antiferromagnétique. La direction d'aimantation de la couche de stockage est alors piégée dans la direction dans laquelle elle se trouvait à l'issue du processus d'écriture. Les dispositifs magnétiques qui comportent une telle couche antiferromagnétique et mettent en oeuvre un chauffage temporaire de cette couche au moment de l'écriture de l'information font partie des dispositifs dits « à écriture assistée thermiquement » ou TAS (« Thermally Assisted Switching »).

Les dispositifs magnétiques à écriture assistée thermiquement sont avantageux car ils permettent de diminuer le risque d'écriture accidentelle lors de la lecture de l'information contenue dans la couche de stockage. Par ailleurs, ils possèdent une bien meilleure rétention que les dispositifs ne mettant pas en oeuvre l'assistance thermique, c'est-à-dire qu'ils ont une meilleure capacité à conserver l'information écrite au cours du temps.

Toutefois, dans ces dispositifs à écriture assistée thermiquement, on chauffe l'empilement magnétique par un courant traversant la barrière tunnel qui produit un échauffement comparable à l'effet Joule produit plus précisément par la relaxation inélastique des électrons chauds traversant par effet tunnel la barrière. La puissance de chauffage produite par le passage du courant à travers la barrière tunnel par unité de surface est donnée par $P=RA.j^2$ où RA est le produit résistance*surface de la jonction et j est la densité de courant traversant la jonction. Du fait de la magnétorésistance tunnel des jonctions tunnels magnétiques (MTJ), le produit RA est différent suivant que la jonction est en configuration magnétique parallèle (P) ou antiparallèle (AP). Si la magnétorésistance TMR est de 100%, le RA de l'état antiparallèle est double de celui de l'état parallèle.

Un problème important intrinsèque à l'écriture TAS est le suivant : lorsqu'on cherche à écrire la couche de stockage d'un élément mémoire ou logique, cet élément peut se trouver aussi bien dans l'état parallèle P que dans l'état antiparallèle AP. Donc si on envoie à travers l'élément mémoire une densité de courant de chauffage prédéterminée, l'élément va plus chauffer s'il est initialement dans l'état antiparallèle que s'il est dans l'état parallèle. Ainsi, si on veut provoquer un échauffement, par exemple de 180°C, pour atteindre une température d'écriture de 230°C en partant d'une température initiale de 50°C, on va devoir appliquer une certaine densité de courant dans l'alignement parallèle. Avec la même densité de courant, si l'élément se trouve dans la configuration antiparallèle, l'échauffement pourrait être de 1.5*180=270°C amenant la température de l'élément à 320°C ce qui constitue une température très élevée. Une telle augmentation de température peut dégrader la qualité structurale de l'empilement et graduellement dépolariser la couche piégée de référence.

Une solution pourrait consister à mesurer l'état magnétique de la jonction avant l'écriture pour ajuster la densité de courant suivant cet état magnétique mais cela ralentirait beaucoup l'écriture puisqu'il faudrait lire avant d'écrire.

On retrouve le même type de difficultés pour des dispositifs magnétiques de type élément logique MLU (« Magnetic Logic Unit ») à écriture assistée thermiquement. On utilise souvent une pluralité de dispositifs MLU connectés en série ou en parallèle ; ces dispositifs MLU peuvent être dans des états magnétiques P ou AP différents. C'est le cas par exemple dans les chaines NAND pour la réalisation d'une mémoire CAM (« Content Adressable Memory ») qui utilisent des MLU connectées en série. Dans ce type d'ensemble de jonctions tunnels connectées en série ou en parallèle, la même densité de courant circule nécessairement à travers les différents éléments qu'ils soient en configuration P ou AP (s'ils sont en série) ou la même tension est appliquée entre leurs électrodes (s'ils sont connectés en parallèles). Ainsi, les différents MLU ne vont pas réagir thermiquement de manière identique selon qu'ils sont en configuration P ou AP pour une même tension ou un même courant. Comme pour les mémoires MRAM à écriture TAS, on retrouve donc un problème de sous ou sur-échauffement des MLU.

L'invention vise à remédier aux inconvénients de l'état de la technique en proposant un dispositif magnétique à écriture assistée thermiquement qui permet de s'affranchir du problème d'élévation de température dépendant de l'état magnétique initial de la couche de stockage.

Pour ce faire, l'invention propose un dispositif magnétique à écriture assistée thermiquement comportant :

- une première couche magnétique dite « couche de référence » ;
- une deuxième couche magnétique dite « couche de stockage » qui présente une direction d'aimantation variable ;
- un espaceur qui sépare la couche de référence et la couche de stockage et les découple magnétiquement ;
- une couche antiferromagnétique de piégeage au contact de la couche de stockage, la couche antiferromagnétique étant apte à piéger la direction d'aimantation de la couche de stockage, ladite couche de stockage présentant au moins deux niveaux de stockage correspondant à deux directions stables d'aimantation piégées ;
- des moyens de chauffage de ladite couche de piégeage de sorte que, lors du chauffage, la température de ladite couche de piégeage dépasse sa température de blocage de sorte que la direction d'aimantation de ladite couche de stockage ne soit plus piégée ;
- des moyens pour appliquer un couple magnétique d'écriture tendant à aligner l'aimantation de la couche de stockage selon l'une des deux directions stables d'aimantation une fois que ladite température de blocage est atteinte ;

ledit dispositif étant caractérisé en ce qu'il comporte des moyens pour appliquer, au moins pendant la phase de chauffage précédent l'atteinte de la température de blocage, un champ magnétique de polarisation de sorte que la direction d'aimantation de ladite couche de stockage soit toujours dans la direction dudit champ magnétique de polarisation au moment d'atteindre la température de blocage.

On notera que l'invention s'applique tout autant aux dispositifs de type mémoire MRAM qu'aux éléments logiques MLU dès lors qu'ils sont à écriture assistée thermiquement.

Selon l'invention, on utilise des moyens pour appliquer à la couche de stockage de l'élément mémoire ou logique écrit par TAS un champ de polarisation (dit également champ de bias) au moins pendant la phase d'échauffement liée à l'écriture, de sorte qu'au cours de la phase d'échauffement (qui se fait sans champ d'écriture appliqué autre que ce champ de bias), la configuration magnétique de la couche de stockage change vers une configuration unique quelle que soit la configuration initiale de la couche de stockage avant le début de la phase de chauffage. La phase de chauffage constitue la phase au cours de laquelle la température de l'empilement augmente de manière à ce que la température de la couche antiferromagnétique de piégeage dépasse sa température de blocage de sorte que la direction d'aimantation de la couche de stockage ne soit plus piégée. Selon un mode de réalisation particulièrement avantageux de l'invention, le champ de polarisation est orienté suivant une direction transverse aux directions possibles d'équilibre de l'aimantation de la couche de stockage au repos.

Le dispositif selon l'invention comporte en outre des moyens pour appliquer le couple magnétique d'écriture, qui peut être soit un champ magnétique d'écriture (différent du champ de bias) ou le couple de transfert de spin exercé par le courant de chauffage, une fois que la phase de chauffage est terminée et avant que le refroidissement ne commence ou tout au moins avant que la couche de stockage ne passe sous sa température de blocage ; on notera que la température de blocage dépend bien entendu de la durée du pulse de chauffage considérée.

Le dispositif selon l'invention s'applique aussi bien à des systèmes à aimantation planaire ou perpendiculaire, avec couche de référence piégée ou couche de référence douce.

Le dispositif selon l'invention peut également présenter une ou plusieurs des caractéristiques ci-dessous, considérées individuellement ou selon toutes les combinaisons techniquement possibles :

- lesdits moyens pour appliquer un couple magnétique d'écriture sont des moyens pour appliquer un champ magnétique d'écriture tendant à aligner l'aimantation de la couche de stockage selon l'une des deux directions stables d'aimantation une fois que ladite température de blocage est atteinte.
- l'amplitude du champ de polarisation est comprise entre 10% et 120% de l'amplitude du champ magnétique d'écriture et préférentiellement entre 25% et 120% de l'amplitude du champ magnétique d'écriture ;
- la direction dudit champ magnétique de polarisation est différente desdites deux directions stables d'aimantation piégées ;
- la direction du champ de polarisation est sensiblement perpendiculaire aux directions stables d'aimantation piégées ;
- lesdits moyens pour appliquer un champ magnétique de polarisation sont formés par une couche de matériau ferromagnétique dur située à proximité de ladite couche de stockage ;
- lesdits moyens pour appliquer un champ magnétique de polarisation sont formés par une couche de matériau ferromagnétique dont l'aimantation est piégée par une couche antiferromagnétique et située à proximité de ladite couche de stockage ;
- lesdits moyens pour appliquer, au moins pendant la phase de chauffage précédent l'atteinte de la température de blocage, un champ magnétique de polarisation sont formés par au moins une couche de matériau ferrimagnétique naturel ou artificiel dont l'aimantation augmente sensiblement lorsque sa température se rapproche de ladite température de blocage et diminue à plus basse température ;
- lesdits moyens pour appliquer, au moins pendant la phase de chauffage précédent l'atteinte de la température de blocage, un champ magnétique de polarisation sont formés par une ligne conductrice de génération de champ dans laquelle circule un courant ;
- les couches magnétiques de stockage et de référence présentent une direction d'aimantation hors du plan desdites couches, ledit champ magnétique de polarisation étant parallèle au plan des couches magnétiques.

La présente invention a également pour objet une mémoire magnétique comportant une pluralité de points mémoire, chaque point mémoire étant un dispositif magnétique selon l'invention.

La présente invention a également pour objet une unité logique comportant une pluralité d'éléments logiques connectés en série ou en parallèle, chaque élément logique étant un dispositif magnétique selon l'invention.

La présente invention a également pour objet un procédé d'écriture d'une information dans la couche de stockage d'un dispositif selon l'invention caractérisé en ce qu'il comporte les étapes suivantes :

- application d'un champ de polarisation sans champ d'écriture tout en injectant un courant dans ledit dispositif de manière à chauffer ce dernier pour atteindre la température de blocage de ladite couche de piégeage ;
- une fois la température de blocage atteinte, application d'un couple magnétique d'écriture à l'aimantation de la couche de stockage pour orienter l'aimantation de la couche de stockage selon l'une des deux directions stables d'aimantation. Ce couple magnétique peut être exercé par application d'un champ magnétique d'écriture ou en utilisant le couple de transfert de spin exercé par le courant de chauffage qui se trouve être naturellement polarisé en spin en traversant la jonction tunnel. Dans ce dernier cas, les deux directions stables de l'aimantation peuvent être atteintes en jouant sur la direction du courant de chauffage traversant la barrière tunnel. Si les électrons traversent la barrière tunnel de la couche de référence vers la couche de stockage, l'alignement parallèle des aimantations des couches de référence et de stockage sera favorisé. Si les électrons traversent la barrière tunnel de la couche de stockage vers la couche de référence, l'alignement antiparallèle sera favorisé.

D'autres caractéristiques et avantages de l'invention ressortiront à la lecture de la description qui suit, en référence aux figures annexées :

- la figure 1 illustre un premier mode de réalisation d'un dispositif magnétique selon l'invention ;
- la figure 2 illustre l'écriture du dispositif de la figure 1 ;
- la figure 3 représente les dynamiques de chauffage du dispositif de la figure 1 pendant son écriture en fonction de l'état magnétique initial du dispositif ;
- la figure 4 illustre l'évolution du champ de piégeage et de l'énergie interfaciale de piégeage de bicouche ferromagnétique/antiferromagnétique avec la température pour différents matériaux antiferromagnétiques ;

- les figures 5 et 6 illustrent l'effet de la couche de polarisation du dispositif de la figure 1 sur le désalignement de l'aimantation de la couche de stockage par rapport à des configurations parallèle et antiparallèle relativement à l'aimantation de la couche de référence ;
- la figure 7 illustre un second mode de réalisation d'un dispositif magnétique selon l'invention ;
- la figure 8 illustre un troisième mode de réalisation permettant de minimiser le désalignement induit par la présence du champ de polarisation objet de la présente invention ;
- la figure 9 illustre un quatrième mode de réalisation du dispositif selon l'invention ;
- la figure 10 illustre un cinquième mode de réalisation d'un dispositif selon l'invention lorsque ce dernier est un élément logique « Magnetic Logic Unit » ;
- la figure 11 représente une pluralité de dispositifs tels que celui de la figure 10 connectés en série.

Pour plus de clarté, les éléments identiques ou similaires sont repérés par des signes de référence identiques sur l'ensemble des figures.

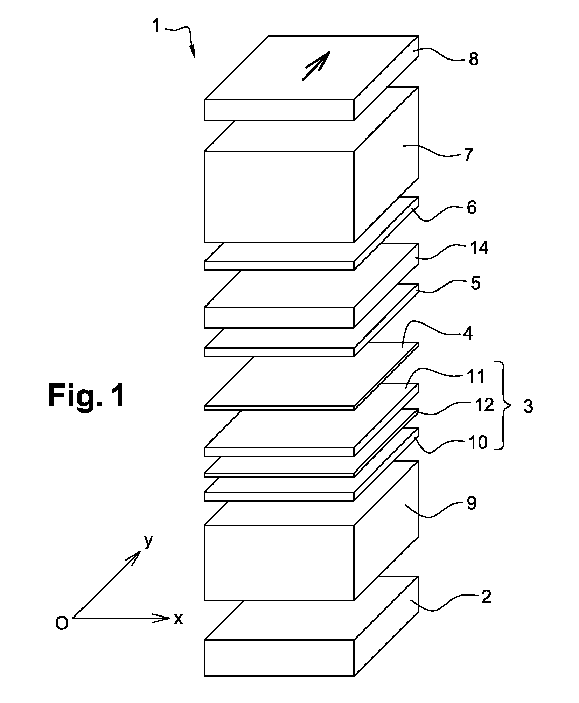

La figure 1 représente un dispositif magnétique 1 à écriture assistée thermiquement selon un premier mode de réalisation de l'invention.

Le dispositif 1 comporte successivement :

- une couche tampon 2 ;
- une première couche antiferromagnétique 9 ;
- une couche de référence 3 ;
- un espaceur 4 ;
- une couche de stockage 5 séparée de la couche de référence 3 par ledit espaceur 4 ;
- une seconde couche antiferromagnétique 14
- une couche fonctionnelle liée à la fabrication 6 ;
- une couche d'adaptation 7 ;
- une couche de polarisation 8.

La couche de référence 3 est ici un empilement tricouche antiferromagnétique synthétique constitué de deux couches magnétiques 10 et 11 séparées par une couche conductrice non magnétique 12 apte à induire un alignement antiparallèle entre les aimantations des couches magnétiques adjacentes.

La première couche antiferromagnétique 9 peut être par exemple en PtMn d'épaisseur comprise entre 12 et 30 nm ou en NiMn d'épaisseur comprise entre 20nm et 50nm. La première couche antiferromagnétique 9 est de préférence réalisée dans un matériau antiferromagnétique qui présente une température de blocage élevée, typiquement supérieure à 370°C. Les matériaux cités ci-dessus pour la couche antiferromagnétique 9 ne sont donnés qu'à titre illustratif et d'autres matériaux pourraient être utilisés sans sortir du cadre de l'invention.

La couche magnétique 10 peut par exemple être constituée d'un alliage cobalt-fer, tandis que la couche magnétique 11 peut être aussi constituée d'un alliage de CoFe éventuellement d'une autre composition que la couche 10 ou de cobalt-fer-bore particulièrement si l'espaceur 4 est une barrière tunnel de MgO. On peut également réaliser les deux couches magnétiques 10 et 11 dans le même alliage magnétique. Chaque couche magnétique 10 et 11 présente de préférence une épaisseur comprise entre 1 et 4 nm. Les deux couches magnétiques 10 et 11 présentent de préférence des moments magnétiques voisins, de façon à ce que le champ rayonné par l'ensemble des deux couches magnétiques 10 et 11 au niveau de la couche de stockage 5 soit le plus faible possible.

La couche conductrice non magnétique 12 peut par exemple être réalisée en ruthénium d'épaisseur comprise entre 0.5nm et 0.9nm, épaisseurs pour lesquelles il est connu que le ruthénium induit un couplage antiparallèle entre aimantations des couches magnétiques adjacentes. Les deux couches magnétiques 10 et 11 sont couplées antiparallèlement à travers la couche conductrice non magnétique 12. La direction d'aimantation des deux couches magnétiques 10 et 11 est figée par la première couche antiferromagnétique 9, tant que le dispositif magnétique est à une température inférieure à la température de blocage du matériau antiferromagnétique qui constitue la première couche antiferromagnétique 9. Les matériaux constitutifs d'une couche de référence sont bien connus de l'homme du métier et ne sont donnés ici qu'à titre indicatif, sans pour autant restreindre l'invention.

Le dispositif magnétique comporte ensuite la couche de stockage 5 séparée de la couche de référence 3 par l'espaceur 4. L'espaceur 4 peut être une barrière tunnel sélectionnée dans un groupe comprenant les oxydes d'aluminium $AlO_x$, de titane $TiO_x$ et l'oxyde de magnésium MgO. Alternativement, l'espaceur 4 peut être constitué d'un semiconducteur. Ainsi, l'espaceur peut être constitué de silicium, de germanium ou de GaAs. On peut également réaliser l'espaceur 4 dans une couche métal/oxyde hétérogène comme une couche à chemins de courant confinés constituée d'une barrière isolante par exemple en Alumine d'épaisseur 2 nm percée de canaux conducteurs qui sont par exemple en cuivre de diamètre nanométrique, typiquement entre 1 et 4nm. L'espaceur 4 présente de préférence une épaisseur comprise entre 0.6nm et 5 nm.

La couche de stockage 5 est une couche magnétique qui présente une direction d'aimantation variable. Cette couche de stockage 5 peut être une monocouche magnétique ou un empilement de couches. La couche de stockage 5 peut par exemple être constituée d'un empilement de couches comportant :

- une couche constituée d'un matériau ferromagnétique présentant une structure cristallographie cubique face centrée au contact de la deuxième couche antiferromagnétique 14 ;

- une couche de transition structurale amorphe ou quasi-amorphe au contact de la couche ferromagnétique de structure cristallographique cubique face centrée ;
- une couche ferromagnétique de structure cristallographique cubique centrée comme par exemple un alliage CoFe riche en Fe ou alors une couche de CoFeB amorphe au moment du dépôt des couches mais cristallisant sous la forme cubique centrée lorsque l'empilement est recuit.

Ce type de couche de stockage est particulièrement intéressant dans le cas où l'espaceur 4 est une barrière tunnel à base de MgO dont la structure cristallographique est cubique centrée.

La couche de stockage 5 peut également être constituée d'un empilement tricouche antiferromagnétique synthétique.

Dans l'exemple de la figure 1, la couche de stockage 5 est constituée d'une monocouche ; elle est suivie de la seconde couche antiferromagnétique 14. Cette monocouche peut par exemple être constituée d'un alliage cobalt-fer-bore. La couche de stockage présente de préférence une épaisseur comprise entre 1 et 4 nm.

Bien entendu les caractéristiques de la couche de stockage ne sont données ici qu'à titre indicatif, et l'homme du métier saurait adapter l'invention à d'autres types de couches de stockage.

La seconde couche antiferromagnétique 14 permet de piéger la direction d'aimantation de la couche de stockage 5 lors de la lecture, et permet la libération de la direction d'aimantation de la couche de stockage 5 lors de l'écriture. La seconde couche antiferromagnétique 14 peut par exemple être en IrMn d'épaisseur comprise entre 5 et 7 nm. La seconde couche antiferromagnétique 14 présente de préférence une température de blocage suffisamment élevée pour qu'en l'absence de chauffage, la seconde couche antiferromagnétique 14 piège efficacement la direction d'aimantation de la couche de stockage 5 sur toute la gamme de température d'opération du dispositif. Toutefois, cette température de blocage ne doit pas être trop élevée pour qu'il ne soit pas trop difficile de libérer la direction d'aimantation de la couche de stockage 5, mais aussi pour pouvoir libérer la direction d'aimantation de la couche de stockage 5 sans libérer la direction d'aimantation de la couche de référence 3. Ainsi, la seconde couche antiferromagnétique 14 présente de préférence une température de blocage comprise entre 200 et 300°C.

Le dispositif magnétique 1 selon l'invention comporte en outre une couche de polarisation 8 pour appliquer un champ magnétique de polarisation de sorte que la direction d'aimantation de la couche de stockage 5 soit toujours dans la direction dudit champ magnétique de polarisation au moment d'atteindre la température blocage de la seconde couche antiferromagnétique 14.

La couche tampon 2 sert de base à la croissance des autres couches du dispositif magnétique. Cette couche tampon 2 est de préférence réalisée dans un matériau non-magnétique. Ici, la couche 2 est une couche de tantale ou une multicouche à base de couche de Ta et de Ru pouvant avoir une épaisseur de 1 à 50nm chacune. Bien entendu, ce matériau n'est donné qu'à titre illustratif, sans restreindre l'invention.

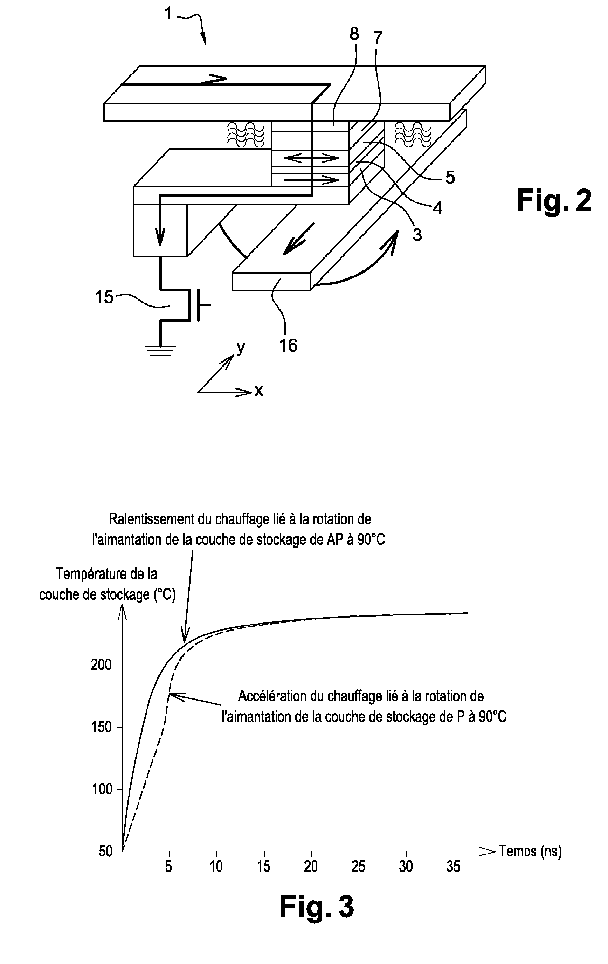

Le fonctionnement en écriture du dispositif magnétique 1 à écriture assistée thermiquement est illustrée en figure 2.

Par souci de simplification seules la couche de stockage 5, la couche de référence 3, l'espaceur 4, la couche d'adaptation 7 et la couche de polarisation 8 sont représentés.

La couche de référence possède une aimantation de direction piégée dans le plan de la couche de référence 3. A titre illustratif, on considérera ici que l'aimantation de la couche de référence 3 piégée par sa première couche antiferromagnétique est suivant la direction +Ox dans le repère plan Oxy parallèle aux plans des couches de l'empilement.

La couche de stockage 5 possède une direction d'aimantation variable avec deux directions stables d'aimantation : la première sensiblement suivant +Ox (état P) et la seconde sensiblement suivant -Ox (état AP).

Le principe de l'invention réside notamment dans la présence d'un moyen (en l'espèce la couche de polarisation 8) permettant d'appliquer un champ de polarisation (dit également champ de bias) orienté suivant la direction Oy ou -Oy, donc perpendiculaire aux directions possibles de l'aimantation de la couche de stockage 5 au repos (et parallèle au plan des couches).

Sur la figure 1, la couche de polarisation 8 est une couche de matériau dur de $Co_{80}Cr_{20}$ d'une épaisseur de quelques nanomètres (par exemple 5 nm) formant un aimant permanent créant une champ de polarisation transverse suivant la direction Oy. La « dureté » d'une couche magnétique se définit par rapport à la valeur du champ magnétique coercitif nécessaire au renversement de l'aimantation de la couche. Telle couche magnétique sera donc réputée plus « dure » si son champ coercitif est plus fort.

Ce champ de polarisation a une influence négligeable sur l'orientation de l'aimantation de la couche de référence 3 car celle-ci est fortement piégée par l'interaction avec la première couche antiferromagnétique 9. Si par ailleurs la couche de référence 3 est une couche antiferromagnétique synthétique, l'influence du champ de polarisation est encore plus réduite du fait que le moment magnétique de la couche de référence 3 est globalement faible. La couche de matériau dur 8 doit être suffisamment éloignée de l'espaceur faisant office de barrière tunnel 4 pour ne pas chauffer au point qu'elle se désaimante pendant le fonctionnement du dispositif. C'est le but de la couche épaisse d'adaptation 7, par exemple réalisée en Ta. Cette couche 7 peut également jouer le rôle de barrière thermique dans l'empilement permettant de mieux confiner la chaleur produite au voisinage de la barrière tunnel au moment de l'écriture. On notera que cette couche 8 de matériau dur pourrait être aussi sous le dispositif dans la mesure où le matériau ferromagnétique NiMn de la première couche antiferromagnétique 9 constitue une bonne barrière thermique à la diffusion de la chaleur, dès lors que le champ de polarisation qu'elle rayonne permet d'orienter l'aimantation de la couche de stockage lors de la phase d'échauffement. On notera également que cette couche n'est pas nécessairement traversée par le courant injecté au-travers de l'empilement. La couche d'adaptation 7 sert également à ajuster la distance entre la couche de polarisation transverse 8 et la couche de stockage 5 permettant par là même d'ajuster la valeur du champ rayonné par la couche de polarisation sur la couche de stockage.

S'agissant de la couche fonctionnelle 6, cette dernière peut par exemple être une fine couche de Ru (2nm par exemple). Cette couche 6 est une couche purement fonctionnelle qui sert dans le procédé de gravure de la jonction tunnel à détecter quand on arrive à la base de l'électrode supérieure de Ta et qu'on va commencer à attaquer la seconde couche antiferromagnétique. Il s'agit donc juste d'une couche de détection dans le procédé de gravure dont on peut s'affranchir en utilisant un autre procédé de gravure.

Comme mentionné ci-dessus, on peut également envisager d'utiliser une couche de barrière thermique (par exemple en BiTe ou en GeSbTe) insérée entre la seconde couche antiferromagnétique 14 et la couche de matériau dur 8 (en plus ou à la place de la couche 7 de Ta).

Pour permettre l'écriture d'une information dans la couche de stockage 5, le dispositif magnétique comporte un transistor 15 qui est conducteur en mode écriture et qui permet d'assurer le passage d'un courant perpendiculairement à l'empilement. En outre, le dispositif magnétique comporte une ligne conductrice 16 située au dessous de l'empilement magnétique. La ligne conductrice 16 est agencée de façon à ce que, lorsqu'elle est traversée par un courant électrique, elle crée un champ magnétique suffisant pour renverser l'aimantation de la couche de stockage 3 vers l'une de ses deux positions stables P ou AP.

A l'écriture, le transistor 15 est en mode passant de sorte qu'un courant peut circuler à travers l'empilement provoquant un échauffement de la couche de stockage et de la première couche antiferromagnétique par effet Joule.

Durant cette phase d'échauffement, le champ de polarisation créé par la couche 8 est appliqué à l'empilement ; comme nous le verrons par la suite, ce champ de polarisation peut être appliqué en permanence (cas d'un aimant permanent comme c'est le cas sur la figure 1) ou uniquement durant la phase d'échauffement.

Sous l'effet de ce champ de bias transverse, comme le piégeage de la couche de stockage 5 par la seconde couche antiferromagnétique 14 décroît au fur et à mesure que la température de l'empilement s'élève, l'aimantation de la couche de stockage 5 va s'orienter perpendiculairement à celle de la couche de référence 3 et ce quelle que soit son orientation initiale P ou AP à celle de la couche de référence 3.

En conséquence, la résistance de la jonction tunnel va s'ajuster spontanément au cours de l'écriture à une valeur unique intermédiaire entre la résistance dans l'état P et la résistance dans l'état AP de la jonction. Plus précisément, dans les magnétorésistances tunnels MTJ, la conductance G (inverse de la résistance R, G=1/R) varie comme le cosinus de l'angle entre les aimantations des couches de stockage 5 et de référence 3. En conséquence, avec un angle égal à 90°, la conductance de la jonction est juste au milieu entre la conductance correspondant à une situation parallèle et la conductance correspondant à une situation antiparallèle :

Si on appelle $G_0$ cette conductance à 90°, on a $G_0 = 1/2 (G_P + G_{AP})$ ou en d'autres termes $1/R_0 = \frac{1}{2}(1/R_P + 1/R_{AP})$, les indices P et AP désignant respectivement les configurations P et AP.

Grace à cette réorientation spontanée de l'aimantation de la couche de stockage 5 pendant la phase de chauffage toujours dans la même direction quel que soit l'état initial du dispositif, la température asymptotiquement atteinte par le dispositif pour une densité de courant donnée va être la même quel que soit son état initial. Cette configuration permet donc de résoudre le problème d'élévation de température dépendant de l'état initial du dispositif. Seule la dynamique de chauffage va changer suivant l'état initial du dispositif mais pas la température finale atteinte.

La dynamique de chauffage est illustrée sur la figure 3 qui représente l'évolution de la température de la couche de stockage en fonction du temps pour deux états initiaux P (courbe pointillée) et AP (ligne continue).

Si le dispositif 1 est initialement dans l'état antiparallèle, la puissance de chauffage initiale par élément de surface est donnée par la relation : $P=(RA)_{AP}(V).j^2$ où $(RA)_{AP}(V)$ indique le produit résistance*surface de la MTJ dans l'état AP à la tension V de chauffage et j est la densité de courant traversant le dispositif. Cette relation peut encore s'écrire : $P=(A/G)_{AP}(V).j^2$, où $(G/A)_{AP}(V)$ représente la conductance par unité de surface de la MTJ dans l'alignement AP à la tension V.

En revanche, si le dispositif 1 est dans l'état parallèle, la puissance de chauffage initiale par élément de surface est donnée par la relation : $P=(RA)_P(V).j^2$ où $(RA)_P(V)$ indique le produit résistance*surface de la MTJ dans l'état P à la tension V de chauffage. Cette relation peut encore s'écrire : $P=(A/G)_P(V).j^2$, où $(G/A)_P (V)$ représente la conductance par unité de surface de la MTJ dans l'alignement P à la tension V.

Si le chauffage est contrôlé en courant c'est-à-dire en imposant un courant de chauffe donné (courant de chauffe=j*section de la jonction tunnel), dans la mesure où $R_{AP}$ est le plus souvent supérieure à $R_P$, le chauffage initial de la MTJ va être initialement plus rapide en partant de la configuration initiale AP puis la puissance de chauffage va automatiquement baisser vers $P=(RA)_0(V).j^2$ lorsque l'aimantation de la couche de stockage 5 va tourner et s'orienter vers le champ de polarisation, $(RA)_0(V)$ désignant le produit résistance*surface de la MTJ pour un angle de 90° entre les aimantations des couches destockage 5 et de référence 3. En d'autres termes, après une évolution rapide du chauffage liée à la configuration AP initiale, on observe un ralentissement du chauffage lié à la rotation de l'aimantation de la couche de stockage 5 de AP à 90° par rapport à la couche de référence 3.

Au contraire, l'élévation de température va être plus lente partant de la configuration P mais la puissance de chauffage va augmenter vers $P=(RA)_0(V).j^2$ lorsque l'aimantation de la couche de stockage 5 va tourner et s'orienter suivant le champ de polarisation. En d'autres termes, après une évolution lente du chauffage liée à la configuration P initiale, on observe une accélération du chauffage liée à la rotation de l'aimantation de la couche de stockage 5 de P à 90° par rapport à la couche de référence 3.

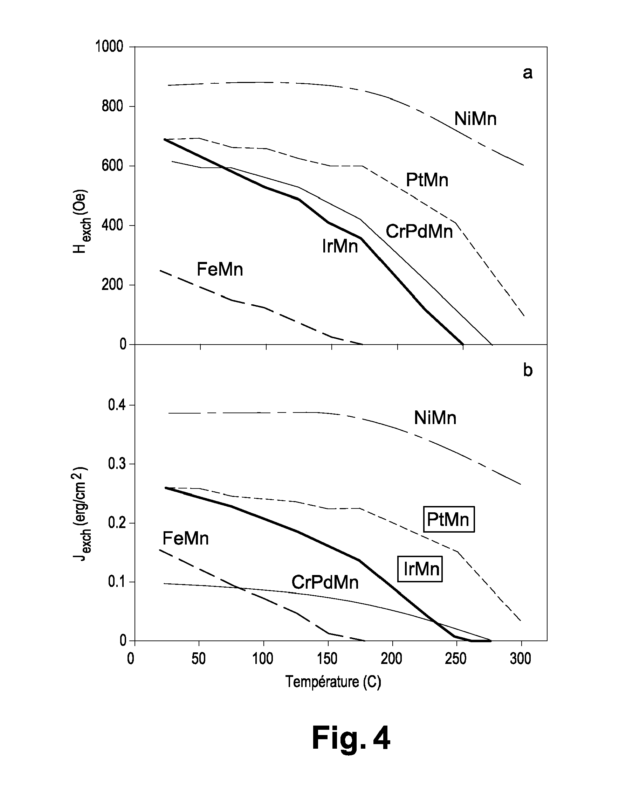

Cette rotation de l'aimantation de la couche de stockage 5 vers le champ de polarisation résulte de la décroissance avec la température du champ de piégeage par la seconde couche antiferromagnétique 14 comme illustré sur la figure 4 pour différents matériaux antiferromagnétiques.

Quelle que soit la situation initiale, on constate donc que du fait de la baisse graduelle avec la température du champ de piégeage, la réorientation de l'aimantation de la couche stockage 5 se fait progressivement au fur et à mesure que la température s'élève mais, in-fine, la puissance de chauffage devient la même quel que soit l'état initial et la température asymptotique devient donc la même au-delà d'un temps de quelques nanosecondes (typiquement de 10ns) dans des conditions usuelles de fonctionnement des dispositifs de type MRAM TAS (càd $(RA)_P\sim30\Omega.\mu m^2$ et $j\sim2.10^6$A/cm$^2$).

Un raisonnement identique sera détaillé ultérieurement pour les dispositifs MLU.

Dans certains cas moins fréquents, la résistance $R_{AP}$ est inférieure à la résistance $R_P$, mais le raisonnement ci-dessus reste applicable en inversant les références P et AP.

Si le chauffage est contrôlé en tension, la puissance de chauffe par unité de surface peut s'écrire dans l'alignement antiparallèle suivant la relation suivante : $P=V^2/(RA)_{AP}(V)$ et dans l'état parallèle : $P=V^2/(RA)_P(V)$. Dans ce cas, la magnétorésistance MTJ chauffera plus initialement dans l'état P que dans l'état AP mais les puissances de chauffage s'équilibreront là aussi après rotation de l'aimantation de la couche de stockage dans la direction du champ de polarisation.

Une fois la phase de chauffage terminée, on atteint une température supérieure ou égale à la température de blocage de la seconde couche antiferromagnétique.

Pour écrire une information dans la couche de stockage 5, on envoie un courant à travers le conducteur 16 de façon à créer un champ magnétique qui va orienter l'aimantation de la couche de stockage 5 soit en configuration P soit en configuration AP. Dès que l'aimantation de la couche de stockage s'est orientée dans cette nouvelle direction (typiquement 3ns après l'application du champ magnétique), le courant de chauffage à travers le transistor 15 peut être coupé de sorte que la couche de stockage et la couche antiferromagnétique adjacente 14 se refroidissent dans le champ appliqué. Puis on coupe le courant dans le conducteur 16 pour supprimer le champ appliqué. La seconde couche antiferromagnétique 14 étant redevenue antiferromagnétique, elle piège la direction d'aimantation de la couche de stockage 5 dans la direction dans laquelle elle se trouve.

De façon alternative, au lieu d'utiliser un champ magnétique pour orienter l'aimantation de la couche de stockage 5 soit en configuration P soit en configuration AP, on peut aussi utiliser le couple de transfert de spin exercé par le courant de chauffage sur l'aimantation de la couche de stockage 5. Ce courant de chauffage est en effet naturellement polarisé en spin en traversant la barrière tunnel. Si sa densité est suffisamment élevée (typiquement de l'ordre de 1 à $4.10^6$A/cm$^2$), il va orienter l'aimantation de la couche de stockage vers la configuration P ou la configuration AP suivant son sens à travers la jonction tunnel. Si les électrons associés à ce courant se déplacent de la couche de référence vers la couche de stockage, la configuration P est favorisée. Si les électrons circulent de la couche de stockage vers la couche de référence, la configuration AP est favorisée. Si on utilise ainsi le couple de transfert de spin associé au courant de chauffage pour commuter l'aimantation de la couche de stockage, alors le conducteur 16 destiné à créer le champ magnétique d'écriture n'est pas nécessaire.

Si l'écriture est effectuée en utilisant le couple de transfert de spin au lieu du couple dû à un champ magnétique, il conviendra alors de décroitre le courant de chauffage progressivement par exemple en quelques nanosecondes pour permettre au couple de transfert de spin d'être encore effectif pendant le refroidissement de la jonction tunnel.

Il est à noter que pendant cette écriture, l'aimantation de la couche de référence 3 ne bouge pas car elle est piégée par la première couche antiferromagnétique 9 dont la température de blocage est plus élevée que celle de la seconde couche antiferromagnétique 14.

Pour des raisons de consommation énergétique, le champ d'écriture est préférentiellement appliqué vers la fin de la phase de chauffage (i.e. une fois que la température de blocage est atteinte) et avant que le refroidissement ne commence (ou tout au moins avant que la température de la seconde couche antiferromagnétique ne passe sous la température de blocage, cette dernière s'entendant pour la durée du pulse de chauffage considérée).

Comme indiqué précédemment, le champ de polarisation est, suivant ce premier mode de réalisation, créé au moyen d'une couche de matériau dur située au voisinage de la jonction tunnel. On notera que cette couche de matériau dur formant un aimant permanent peut être dans l'empilement, au-dessus de l'empilement (cas de la figure 1) ou en-dessous. Les caractéristiques de cette couche (aimantation, dimension, positionnement par rapport à la jonction) doivent être ajustées de sorte que le champ de polarisation produit au niveau de la couche de stockage soit suffisant pour orienter l'aimantation de celle-ci sensiblement transversalement à celle de la couche de référence.

Suivant ce premier mode de réalisation, le champ de polarisation est appliqué en permanence puisqu'il est créé ici par une couche de matériau dur (aimant permanent) ; il est donc souhaitable que ce champ ne soit pas trop fort par rapport au champ d'écriture pour que le désalignement de l'aimantation de la couche de stockage par rapport au champ d'écriture ne soit pas trop fort au moment de l'écriture. Typiquement, on pourra prendre une valeur du champ de bias de l'ordre de la moitié du champ d'écriture.

De façon générale, l'amplitude du champ de polarisation peut être préférentiellement comprise entre 25% et 120% de l'amplitude du champ d'écriture et préférentiellement dans la gamme 30% à 75% du champ d'écriture. Si le champ de polarisation est trop faible, il peut ne pas suffire à polariser l'aimantation de la couche de stockage dans le même état quel que soit l'état initial avant le démarrage du chauffage. Si au contraire le champ est trop fort par rapport au champ d'écriture, l'aimantation de la couche de stockage risque de trop dévier de l'alignement P ou AP avec l'aimantation de la couche de référence de sorte que l'amplitude de magnétorésistance entre les deux états "0" et "1" sera fortement réduite.

La conséquence du champ de bias sur le désalignement en terme de perte de magnétorésistance parce qu'on ne commute pas de l'alignement parallèle parfait à la configuration antiparallèle parfaite n'est pas critique.

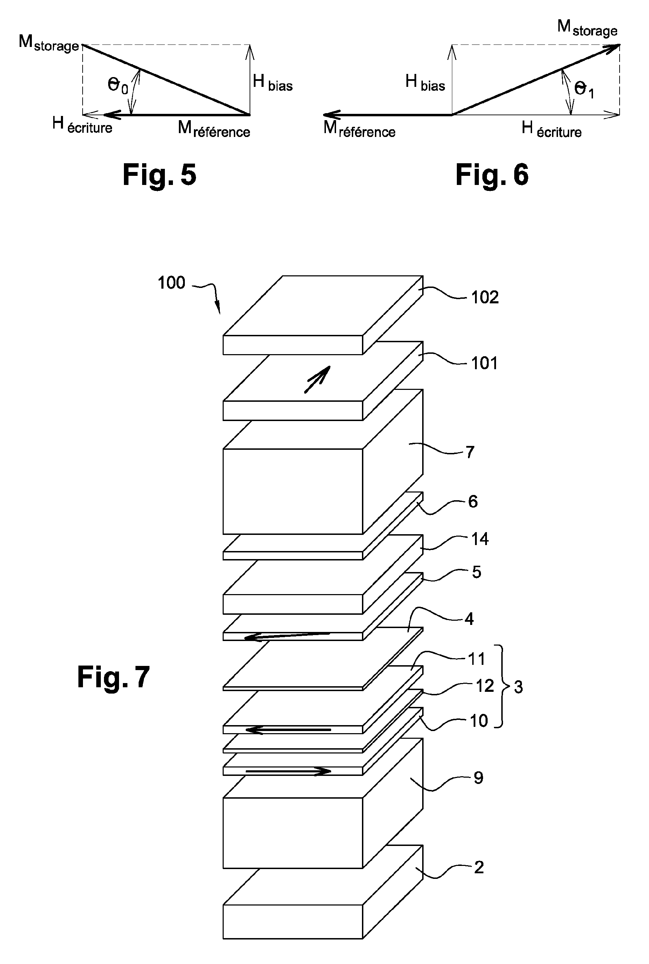

Ainsi, si on suppose par exemple que l'amplitude $H_{bias}$ du champ de polarisation est égale à la moitié de l'amplitude du champ d'écriture $H_{écriture}$, alors l'angle $\theta$ de désalignement entre une aimantation de référence $M_{reference}$ et l'aimantation $M_{storage}$ de la couche de stockage dans le dispositif selon l'invention est donné par $tg\theta = Hbias/Hécriture = 1/2$ soit $\theta = 26°$ (cf. figures 5 et 6 qui illustrent l'effet de la couche de polarisation du dispositif de la figure 1 sur le désalignement par rapport aux configurations parallèle et antiparallèle de référence). En termes de magnétorésistance, ceci implique que l'amplitude de magnétorésistance est réduite de 11% en valeur relative par rapport à son amplitude totale si on passait de l'alignement parallèle parfait à antiparallèle parfait. En d'autres termes, si l'amplitude entre des configurations P et AP parfaites était de 150%, en présence du champ de bias pendant l'écriture, cette amplitude reste égale à 133% : l'amplitude de magnétorésistance reste donc très acceptable.

Un avantage annexe de la présence du champ de polarisation pendant la phase d'écriture est de rendre l'écriture beaucoup plus reproductible. En effet, grâce à ce champ de polarisation, l'aimantation tourne de façon beaucoup plus cohérente qu'en l'absence de ce champ de polarisation transverse. En conséquence, l'état micromagnétique final est mieux défini et plus près d'un état macrospin ou d'un état dit «feuille» (ou « leaf state » en anglais).

La perte de magnétorésistance liée à la présence du champ de polarisation peut être aisément calculée en écrivant comme précédemment: $tg\theta_{0(1)} = +(-)Hbias/Hécriture$ ($\theta_0$ et $\theta_1$ désignant les angles de désalignement de l'aimantation de la couche de stockage par rapport à la direction parallèle ou antiparallèle à la direction de référence Ox du fait de la présence du champ de bias transverse) ; sachant que la conductance G varie en fonction de l'angle $\theta$ entre l'aimantation de la couche de référence et de stockage comme

$$G(\theta) = G_p - \Delta G \frac{(1 - cos\theta)}{2}$$

où $\Delta G$ représente la variation de conductance (magnétoconductance) entre les alignements P et AP parfaits.

En présence de Hbias, l'angle entre les aimantations varie de $\theta_0$ à $\theta_1$ lorsque l'aimantation de la couche de stockage commute d'une position stable à l'autre. Il en résulte que la magnétoconductance effective $\Delta G_{eff}$ est donnée par

$$\Delta G_{eff} = \frac{\Delta G}{\sqrt{1 + \left(\frac{H_{bias}}{H_{ecriture}}\right)^2}}$$

Ainsi, si $H_{bias} = 0.25*H_{écriture}$, la magnétorésistance TMR est réduite de 3% de son amplitude totale. Si $H_{bias} = 0.5*H_{écriture}$, la TMR est réduite de 11% de son amplitude totale.

La lecture de l'information contenue dans la couche de stockage 5 se fait selon les méthodes connues de l'homme du métier, notamment en déterminant la résistance du dispositif.

Pour initialiser le dispositif 1 de la figure 1 au moment de la fabrication du dispositif, il faut d'abord faire le recuit (à une température supérieure à la température de blocage de la première couche antiferromagnétique 9) sous champ qui permet de polariser la couche de référence 3 dans la bonne direction par rapport à la ligne de champ (i.e. perpendiculaire aux lignes de génération du champ telles qu'illustrées sur la figure 2) ; on polarise ensuite la couche 8 de polarisation en matériau dur en appliquant à la température ambiante un champ qui la sature dans la direction souhaitée, c'est-à-dire ici transverse à l'aimantation de la couche de référence donc parallèle aux lignes de génération du champ. Comme ce champ est appliqué à température ambiante (donc inférieure à la température de blocage de la première couche antiferromagnétique 9), il ne modifiera pas la direction de piégeage de la couche de référence.

La figure 7 illustre un second mode de réalisation d'un dispositif 100 magnétique selon l'invention ; ce dispositif 100 est quasi identique (les caractéristiques communes possèdent les mêmes références) au dispositif 1 de la figure 1 à la différence que la couche de polarisation 8 est remplacée par :

- une couche magnétique 101 par exemple constituée d'un alliage cobalt-fer ;
- une troisième couche antiferromagnétique 102.

Cette troisième couche antiferromagnétique 102 permet de piéger par anisotropie d'échange la direction d'aimantation de la couche magnétique 101. La troisième couche antiferromagnétique 102 peut par exemple être en PtMn d'épaisseur comprise entre 5 et 10 nm (par exemple 8 nm). La troisième couche antiferromagnétique 102 présente une température de blocage plus élevée que celle de la deuxième couche antiferromagnétique 14 et moins élevée que celle de la première couche antiferromagnétique 9. Ainsi, la troisième couche antiferromagnétique 14 (PtMn) présente de préférence une température de blocage proche de 300°C tandis que la première couche antiferromagnétique 9 (NiMn) a une température de blocage supérieure ou égale à 350°C et la seconde couche antiferromagnétique 14 (IrMn) a une température de blocage proche de 200°C. Le fait d'avoir des températures de blocage différentes permet notamment d'orienter successivement les aimantations de la couche de référence puis de la couche de polarisation. On retrouve ces différences entre les températures de blocage des matériaux antiferromagnétiques sur la figure 4 qui représente l'évolution de la variation du champ de piégeage et de l'énergie interfaciale de piégeage pour différents matériaux antiferromagnétiques. Il est à noter qu'on pourrait au contraire orienter en premier l'aimantation de la couche de polarisation puis en second celle de la couche de référence. Il faudrait alors que la température de blocage de la couche antiferromagnétique 102 soit supérieure à celle de la couche antiferromagnétique 9.

Pour initialiser le dispositif 100 lors de sa fabrication dans le cas où le matériau de la troisième couche antiferromagnétique 102 qui piège la couche 101 de bias (Température de blocage de l'ordre de 270°C pour le PtMn) a une température de blocage inférieure à celle du matériau de la première couche antiferromagnétique 9 qui piège la couche de référence 3 (Température de blocage de l'ordre de 350°C pour NiMn) il convient d'abord de recuire le dispositif à haute température dans un champ permettant d'orienter la couche de référence 3 dans la bonne direction puis de baisser la température à une température intermédiaire entre les températures de blocage de la troisième et de la première couche antiferromagnétique ; on applique alors un champ dans la direction dans laquelle on veut orienter l'aimantation de la couche de bias 101 puis on finit de refroidir sous ce champ jusqu'à la température ambiante.

Comme nous l'avons mentionné plus haut, la présence du champ de bias dans les dispositifs 1 et 100 des figures 1 et 7 entraîne un désalignement de l'aimantation de la couche de stockage par rapport un alignement parallèle ou antiparallèle parfait. Nous avons montré que ce désalignement n'est pas critique et ne nuit pas au fonctionnement du dispositif. Il est toutefois possible de minimiser l'effet de ce désalignement.

Pour minimiser l'effet de désalignement représenté sur la figure 5, on peut aussi utiliser comme couche créant le champ de polarisation des matériaux présentant une forte aimantation à la température d'écriture (de sorte qu'on crée un champ de polarisation suffisant pendant la phase finale de l'échauffement) mais présentant une plus faible aimantation à plus faible température. Un tel résultat peut être obtenu en utilisant des matériaux ferrimagnétiques naturels ou artificiels dont le point de compensation (i.e. champ magnétique créé sensiblement nul) se situerait dans la plage de température de fonctionnement du dispositif hors écriture (typiquement pour une température comprise entre 0°C et 80°C). Dans ce type de matériau, l'aimantation est nulle au point de compensation et croit au-dessus du point de compensation jusqu'à une température donnée où l'aimantation décroit à nouveau. C'est le cas d'alliages Terre Rare/métaux de transition (par exemple TbCo, TbFe, DyCo ou DyFe). Le point de compensation s'ajuste en fonction de la concentration relative de Terre Rare et de métal de transition.

On peut également utiliser des matériaux ferrimagnétiques artificiels comportant deux couches couplées antiferromagnétiquement à travers un espaceur (par exemple de Ru) et ayant chacune des variations thermiques différentes en température.

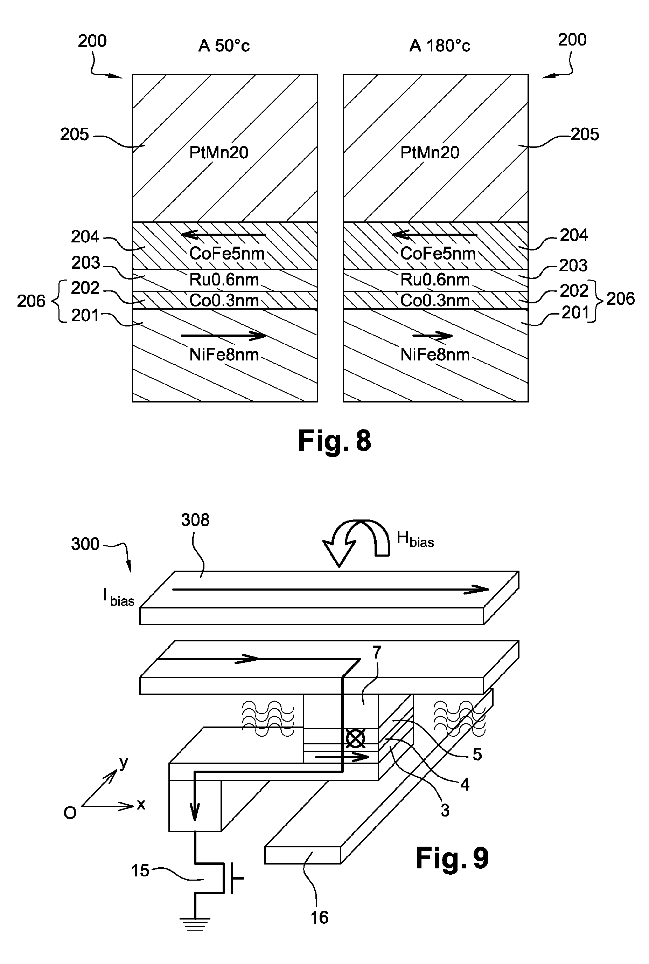

Un exemple d'une telle structure utilisant des matériaux ferrimagnétiques artificiels est illustrée en figure 8.

On peut ainsi remplacer la couche 8 de la figure 1 ou les couches 101 et 102 de la figure 7 par l'empilement 200 de la figure 8.

Cet empilement 200 comporte :

- un bicouche ferromagnétique 206 incluant une couche 201 de NiFe (par exemple sur une épaisseur de 8nm) et une couche 202 de Co (par exemple sur une épaisseur de 0.3nm) ;
- un espaceur 203 (ici du Ru sur une épaisseur de 0.6nm) ;

- une couche ferromagnétique 204 de CoFe (par exemple sur une épaisseur de 5nm).

Dans une telle structure, l'aimantation de la couche ferromagnétique 201 de NiFe (dont la température de Curie est de 800K) décroît plus vite que l'aimantation de la couche ferromagnétique 204 de CoFe (dont la température de Curie est de l'ordre de 1200K). Ainsi, la somme des aimantations des deux couches magnétiques 201 et 204 peut être quasiment nulle à température ambiante (typiquement pour une température de 50°C telle que représentée en partie gauche de la figure 8) mais présenter une valeur importante à la température atteinte par l'empilement 200 au moment de l'écriture de la couche de stockage (par exemple à 180° C tel qu'illustré en partie droite de la figure 8).

La couche ferromagnétique 204 peut être piégée par une couche antiferromagnétique 205, par exemple en PtMn.

En d'autres termes, à la température de fonctionnement du dispositif selon l'invention (hors écriture), typiquement à température ambiante, les aimantations de la bicouche de NiFe/Co et de la couche CoFe se compensent sensiblement.

Par contre à 180°C, l'aimantation de la couche de NFe baisse beaucoup plus que l'aimantation de la couche de CoFe de sorte que le champ de polarisation rayonné sur la couche de stockage pendant la phase terminale du chauffage est positif et de module plus important, de l'ordre de la moitié du champ d'écriture. La couche de Co de 0.3nm au contact de la couche de NiFe a pour but de maximiser le couplage antiferromagnétique à travers le Ru. Le couplage serait fortement diminué si la couche de NiFe était directement en contact avec l'espaceur de Ru de sorte que l'alignement antiparallèle à travers le Ru ne serait pas correctement maintenu en présence du champ d'écriture.

Selon la solution présentée en figure 8, on crée ainsi un champ de polarisation uniquement à la température de fin d'échauffement, ce champ disparaissant presque complètement lorsque la température diminue.

La figure 8 illustre un quatrième mode de réalisation d'un dispositif 300 selon l'invention permettant de s'affranchir des problèmes de désalignement causant une perte de magnétorésistance.

Comme dans le cas de la figure 2, par souci de simplification seules la couche de stockage 5, la couche de référence 3, l'espaceur 4 et la couche d'adaptation 7 sont représentées, les autres couches de l'empilement n'étant pas représentées. Le dispositif 300 est identique à celui des figures 1 et 2 à la différence qu'il ne comporte pas de couche en matériau dur pour la création du champ de polarisation. En revanche, le dispositif 300 comporte une ligne conductrice 308 de génération de champ magnétique de polarisation située au-dessus de l'empilement et perpendiculaire à la ligne d'écriture 16.

Comme précédemment, la couche de référence 3 possède une aimantation de direction piégée dans le plan de la couche de référence 3. A titre illustratif, on considérera ici que l'aimantation de la couche de référence 3 piégée par sa première couche antiferromagnétique est suivant la direction +Ox dans le repère plan Oxy parallèle aux plans des couches de l'empilement.

On notera que la ligne 308 pourrait parfaitement être au-dessous de l'empilement tandis que la ligne d'écriture 16 serait au-dessus.

Au moment du chauffage, on fait passer un courant dans la ligne 308 générant un champ transverse Hbias (orienté suivant la direction Oy ou -Oy, donc perpendiculaire aux directions possibles de l'aimantation de la couche de stockage 5 au repos) sur la couche de stockage 5 de la jonction (et parallèle au plan des couches).

La couche de stockage 5 est ainsi polarisée transversalement par le champ Hbias pendant la phase terminale du chauffage. Ce champ de polarisation est ensuite coupé (i.e. on ne fait plus passer de courant dans la ligne 308) pendant la phase de refroidissement pour que seul le champ d'écriture soit appliqué pendant la phase de refroidissement via la ligne conductrice 16.

Selon un autre mode de réalisation non représenté, on peut également utiliser en tant que moyens de génération du champ de polarisation un aimant permanent situé au-dessus ou au-dessous de plusieurs points mémoire et recouvrant l'ensemble desdits points mémoire. Cet aimant permanent est par exemple réalisé dans un matériau dur.

Selon un autre mode de réalisation non représenté, on peut également utiliser en tant que moyens de génération du champ de polarisation deux aimants permanents situés de part et d'autre de plusieurs points mémoire.

Dans l'ensemble des modes de réalisation décrits en référence aux figures 1 à 8, les couches magnétiques présentent une direction d'aimantation dans le plan, c'est-à-dire que les aimantations des couches magnétiques sont parallèles au plan dans lequel chaque couche se trouve. Toutefois, on peut également réaliser le dispositif magnétique selon l'invention avec des aimantations hors du plan, c'est-à-dire que les aimantations des couches magnétiques seraient perpendiculaires au plan dans lequel se trouvent les couches magnétiques. Dans ce cas, la couche de polarisation (qui peut être par exemple une couche ferromagnétique piégée par une couche antiferromagnétique) crée un champ de bias dans le plan des couches de sorte qu'au moment du chauffage, comme l'anisotropie perpendiculaire diminue, l'aimantation de la couche de stockage s'oriente dans le plan des couches (i.e. sensiblement parallèlement à la direction du champ de bias). Pendant ce temps, l'aimantation de la couche de référence reste orientée hors du plan de sorte que les aimantations des couches de stockage et de référence se trouvent en configuration à 90° dans la phase terminale du chauffage quel que soit l'état initial P ou AP.

Le dispositif magnétique selon l'invention tel qu'il vient d'être décrit en tant que point mémoire peut également être utilisé en tant qu'élément logique (« Magnetic Logic Unit »).

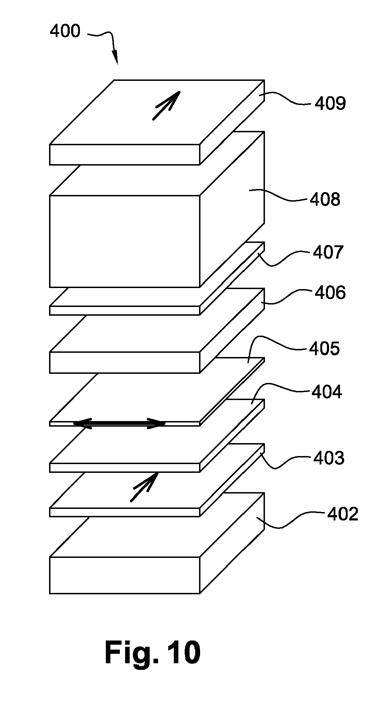

La figure 10 illustre ainsi un élément logique « Magnetic Logic Unit » 400.

Contrairement au dispositif 1 de la figure 1, ce dispositif 400 comporte une couche de référence 403 qui n'est pas piégée.

Plus précisément, le dispositif 400 comporte successivement :

- une couche tampon 402 ;
- une couche de référence 403 ;
- un espaceur 404 ;
- une couche de stockage 405 séparée de la couche de référence 403 par ledit espaceur 404 ;
- une couche antiferromagnétique 406 de piégeage de l'aimantation de la couche de stockage 405 ;
- une couche fonctionnelle liée à la fabrication 407 ;
- une couche d'ajustement 408 ;
- une couche de polarisation 409.

La couche de référence 403 a ici une direction d'aimantation variable.

Ce dispositif permet de lire l'information stockée dans la couche de stockage 405 sans avoir à utiliser de valeur de résistance de référence. En effet, ce dispositif magnétique permet de réaliser une lecture différentielle de l'information contenue dans la couche de stockage 405 à l'aide de la couche de référence 403.

Pour cela, on mesure la résistance du dispositif quand la direction d'aimantation de la couche de référence 403 est dans un sens, puis on mesure la résistance de ce même dispositif quand la direction d'aimantation de la couche de référence 403 est dans l'autre sens. On compare ensuite les valeurs de ces deux résistances de façon à en déduire la direction de l'aimantation de la couche de stockage.

Pour cela, on oriente, avec un premier pulse de champ magnétique, la direction d'aimantation de la couche de référence dans un sens prédéterminé. On mesure alors la résistance du dispositif. On applique ensuite un deuxième pulse de champ magnétique de façon à orienter la direction d'aimantation de la couche de référence dans le sens opposé au premier sens prédéterminé. On mesure alors à nouveau la résistance du dispositif. Après chaque pulse de courant, on connaît la direction d'aimantation de la couche de référence, puisqu'on connaît la direction des pulses de champs magnétiques appliqués. Par conséquent, en comparant la résistance du dispositif après le premier pulse de courant et après le deuxième pulse de courant, on en déduit la direction d'aimantation de la couche de stockage.

La couche de référence 403 est ici constituée d'une couche magnétique qui présente une direction d'aimantation variable, par exemple à base d'un alliage cobalt-fer-bore, présentant de préférence une épaisseur comprise entre 1 et 4 nm.

Le dispositif magnétique comporte ensuite la couche de stockage 405 séparée de la couche de référence 403 par l'espaceur 404. L'espaceur 4 peut être une barrière tunnel sélectionnée dans un groupe comprenant les oxydes d'aluminium $AlO_x$, de titane $TiO_x$ et l'oxyde de magnésium MgO. Alternativement, l'espaceur 404 peut être constitué d'un semiconducteur. Ainsi, l'espaceur peut être constitué de silicium, de germanium ou de GaAs. On peut également réaliser l'espaceur 404 dans une couche métal/oxyde hétérogène comme une couche à chemins de courant confiné constituée d'une barrière isolante par exemple en Alumine d'épaisseur 2 nm percée de canaux conducteurs qui sont par exemple en cuivre de diamètre nanométrique, typiquement entre 1 et 4nm. L'espaceur 404 présente de préférence une épaisseur comprise entre 0.6nm et 5 nm.

La couche de stockage 405 est une couche magnétique qui présente une direction d'aimantation variable. Cette couche de stockage 405 peut être une monocouche magnétique ou un empilement de couches. La couche de stockage 405 peut par exemple être constituée d'un empilement de couches comportant :

- une couche constituée d'un matériau ferromagnétique présentant une structure cristallographie cubique face centrée au contact de la deuxième couche antiferromagnétique ;
- une couche de transition structurale amorphe ou quasi-amorphe au contact de la couche ferromagnétique de structure cubique face centrée ;
- une couche ferromagnétique de structure cristallographique cubique centrée comme par exemple un alliage CoFe riche en Fe ou alors une couche de CoFeB amorphe au moment du dépôt des couches mais cristallisant sous la forme cubique centrée lorsque l'empilement est recuit.

Ce type de couche de stockage est particulièrement intéressant dans le cas où l'espaceur 404 est une barrière tunnel à base de MgO dont la structure cristallographique est cubique centrée.

La couche de stockage 405 peut également être constituée d'un empilement tricouche antiferromagnétique synthétique.

Dans l'exemple de la figure 10, la couche de stockage 405 est constituée d'une monocouche ; elle est suivie de la seconde couche antiferromagnétique 14. Cette monocouche peut par exemple être constituée d'un alliage cobalt-fer-bore. La couche de stockage présente de préférence une épaisseur comprise entre 1 et 4 nm.

La couche antiferromagnétique 406 permet de piéger la direction d'aimantation de la couche de stockage 405 lors de la lecture et en mode standby c'est-à-dire lorsque le point mémoire conserve l'information sans être en train d'être ni lu ni écrit, et permet la libération de la direction d'aimantation de la couche de stockage 405 lors de l'écriture. La couche antiferromagnétique 406 peut par exemple être en IrMn d'épaisseur comprise entre 5 et 7 nm.

Comme précédemment, le dispositif magnétique MLU 400 selon l'invention comporte en outre une couche de polarisation 409 pour appliquer un champ magnétique de polarisation de sorte que la direction d'aimantation de la couche de stockage 405 soit toujours dans la direction dudit champ magnétique de polarisation au moment d'atteindre la température blocage de la couche antiferromagnétique 406. A la différence des modes de réalisation précédent, dans le cas du dispositif 400, la direction d'aimantation de la couche de référence 403 sera également dans la direction du champ magnétique de polarisation au moment d'atteindre la température blocage de la couche antiferromagnétique 406 puisque l'aimantation de la couche de référence 403 n'est pas piégée.

Le fonctionnement en écriture du dispositif magnétique 400 est identique à celui de la figure 1.

A l'écriture, durant la phase d'échauffement, le champ de polarisation créé par la couche 409 est appliqué à l'empilement ; sous l'effet de ce champ de bias transverse, comme le piégeage de la couche de stockage 405 par la couche antiferromagnétique 406 décroit au fur et à mesure que la température de l'empilement s'élève, l'aimantation de la couche de stockage 405 va avoir tendance à s'orienter parallèlement au champ de bias ; il en sera de même de l'aimantation de la couche de référence non piégée 403. Ainsi, les aimantations des couches de stockage 405 et de référence 403 seront parallèles en fin d'échauffement et ce quelle que soit l'orientation initiale P ou AP relativement à celle de la couche de référence 403.

L'avantage précité est moins important pour certains dispositifs MLU qui présentent un couplage entre la couche de stockage et la couche de référence non piégées souvent d'origine magnétostatique ; ce couplage peut être suffisamment fort pour que l'aimantation de la couche de référence revienne spontanément toujours soit parallèle, soit antiparallèle à celle de la couche de stockage. Ceci dépend si la couche de stockage est une couche simple ou antiferromagnétique synthétique et de la façon dont cette couche antiferromagnétique synthétique est décompensée. Si le dispositif se met toujours spontanément dans le même état en champ nul, l'application d'un champ de polarisation, sans nuire, est évidemment moins efficace ; toutefois, même dans ce cas de figure, l'application de ce champ de polarisation peut favoriser une rotation cohérente des aimantations des couches de stockage et de référence au moment de l'écriture ou de la lecture.

Par ailleurs, la présence de ce champ de polarisation prend tout son sens dans d'autres dispositifs de type MLU lorsque le couplage entre la couche de stockage et la couche de référence est minimisé pour que la couche de référence soit la plus douce possible ou ait un comportement symétrique dans le champ appliqué. Dans ce cas, l'application d'un champ de polarisation transverse permet aux aimantations des couches de référence et de stockage d'être parallèles à la fin de l'étape d'échauffement et avant l'application du champ d'écriture. Le chauffage est alors identique que la couche de stockage soit orientée en "0" ou en "1" et on évite les risques d'élévation de température dépendant de l'état magnétique initial de la couche de stockage.

Ce risque d'élévation de température est d'autant plus critique dans le cas d'application où les dispositifs MLU tels que le dispositif 400 de la figure 10 sont connectés en série ou en parallèle et qui peuvent être dans des états magnétiques initiaux différents.

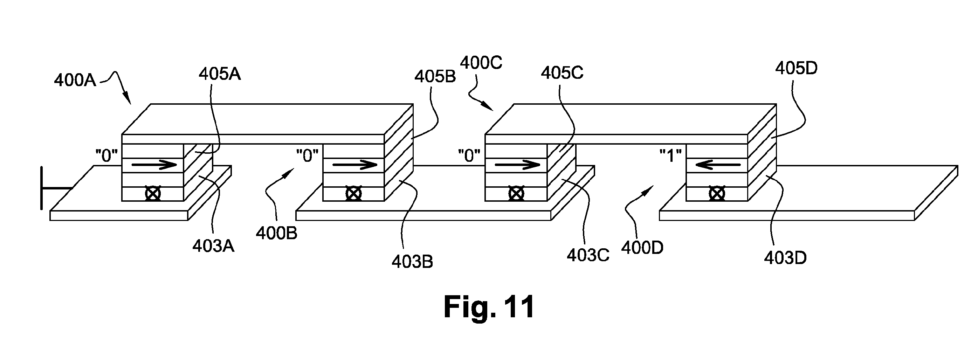

Une telle configuration est ainsi illustrée en figure 11 qui représente quatre dispositifs 400A, 400B, 400C et 400D connectés en série et de structure identique à celle du dispositif 400 de la figure 10. Chacun des dispositifs 400A à 400D est ici représenté dans un état au repos (hors étapes d'écriture ou de lecture). Dans cet état, la présence du champ de polarisation fait que toutes les couches de référence 403A à 403D ont une aimantation orientée spontanément (en champ d'écriture ou de lecture nul) suivant une direction perpendiculaire aux directions d'aimantation des couches de stockage 405A, 405B, 405C et 405D. Lors de l'écriture, on va commencer par échauffer les dispositifs sans appliquer de champ d'écriture de sorte que les aimantations de toutes les couches de stockage 405A à 405D vont avoir tendance à également s'orienter suivant le champ de polarisation de sorte que les dispositifs 400A à 400B le long d'une même chaine en série chaufferont de façon identique.

Selon ce mode de réalisation, le champ de bias étant toujours présent (puisqu'il est créé par des couches d'aimant permanent et non pas par un courant circulant dans une ligne de création de champ), ce champ de bias polarise les aimantations des couches de référence perpendiculairement à celles des couches de stockage en l'absence de champ d'écriture ou de lecture.

A la lecture, les couches de référence 403A à 403D sont alors soumises aux champs de lecture qui fait tourner leur aimantation vers la droite ou vers la gauche pour se rapprocher de l'alignement P ou AP vis à vis de l'aimantation de leur couche de stockage respective. Grace à la présence du champ de bias, cette rotation de l'aimantation des couches de référence est très réversible.

Naturellement, l'invention n'est pas limitée aux modes de réalisation décrits en référence aux figures et des variantes peuvent être envisagées sans sortir du cadre de l'invention. En particulier, les matériaux et les épaisseurs choisis pour réaliser les couches tampon, les couches de référence, les couches de stockage et les espaceurs ne sont donnés ici qu'à titre illustratif et d'autres matériaux ou épaisseurs pourraient être utilisés.

**Revendications**

1. Dispositif magnétique (1, 100, 300, 400) à écriture assistée thermiquement comportant :

- une première couche magnétique dite « couche de référence » (3) ;
- une deuxième couche magnétique dite « couche de stockage » (5) qui présente une direction d'aimantation variable ;
- un espaceur (4) qui sépare la couche de référence et la couche de stockage et les découple magnétiquement ;
- une couche antiferromagnétique de piégeage (14) au contact de la couche de stockage, la couche antiferromagnétique étant apte à piéger la direction d'aimantation de la couche de stockage, ladite couche de stockage présentant au moins deux niveaux de stockage correspondant à deux directions stables d'aimantation piégées ;
- des moyens de chauffage (15) de ladite couche de piégeage (14) de sorte que, lors du chauffage, la température de ladite couche de piégeage dépasse sa température de blocage de sorte que la direction d'aimantation de ladite couche de stockage (5) ne soit plus piégée ;
- des moyens (16) pour appliquer un couple magnétique d'écriture tendant à aligner l'aimantation de la couche de stockage (5) selon l'une des deux directions stables d'aimantation une fois que ladite température de blocage est atteinte ;

ledit dispositif (1) étant **caractérisé en ce qu'**il comporte des moyens (8, 101, 102, 200, 308, 409) pour appliquer, au moins pendant la phase de chauffage précédent l'atteinte de la température de blocage, un champ magnétique de polarisation de sorte que la direction d'aimantation de ladite couche de stockage (5) soit toujours dans la direction dudit champ magnétique de polarisation au moment d'atteindre la température de blocage.

2. Dispositif selon la revendication précédente **caractérisé en ce que** lesdits moyens (16) pour appliquer un couple magnétique d'écriture sont des moyens pour appliquer un champ magnétique d'écriture tendant à aligner l'aimantation de la couche de stockage (5) selon l'une des deux directions stables d'aimantation une fois que ladite température de blocage est atteinte.

3. Dispositif magnétique selon la revendication précédente, **caractérisé en ce que** l'amplitude du champ de polarisation est comprise entre 10% et 120% de l'amplitude du champ d'écriture et préférentiellement entre 25% et 120% de l'amplitude du champ d'écriture.

4. Dispositif magnétique selon l'une des revendications précédentes **caractérisé en ce que** la direction dudit champ magnétique de polarisation est différente desdites deux directions stables d'aimantation piégées.

5. Dispositif magnétique selon la revendication précédente **caractérisé en ce que** la direction du champ de polarisation est sensiblement perpendiculaire aux directions stables d'aimantation piégées.

6. Dispositif magnétique selon l'une des revendications précédentes **caractérisé en ce que** lesdits moyens pour appliquer un champ magnétique de polarisation sont formés par une couche de matériau ferromagnétique dur située à proximité de ladite couche de stockage.

7. Dispositif magnétique selon l'une des revendications précédentes 1 à 5 **caractérisé en ce que** lesdits moyens pour appliquer un champ magnétique de polarisation sont formés par une couche de matériau ferromagnétique dont l'aimantation est piégée par une couche antiferromagnétique et située à proximité de ladite couche de stockage.

8. Dispositif magnétique selon l'une des revendications 1 à 5 **caractérisé en ce que** lesdits moyens pour appliquer, au moins pendant la phase de chauffage précédent l'atteinte de la température de blocage, un champ magnétique de polarisation sont formés par au moins une couche de matériau ferrimagnétique naturel ou artificiel dont l'aimantation augmente sensiblement lorsque sa température se rapproche de ladite température de blocage et diminue à plus basse température.

9. Dispositif magnétique selon l'une des revendications 1 à 5, **caractérisé en ce que** lesdits moyens pour appliquer, au moins pendant la phase de chauffage précédent l'atteinte de la température de blocage, un champ magnétique de polarisation sont formés par une ligne conductrice de génération de champ dans laquelle circule un courant.

10. Dispositif magnétique selon l'une des revendications précédentes **caractérisé en ce que** les couches magnétiques de stockage et de référence présentent une direction d'aimantation hors du plan desdites couches, ledit champ magnétique de polarisation étant parallèle au plan des couches magnétiques.

11. Mémoire magnétique comportant une pluralité de points mémoire, chaque point mémoire étant un dispositif magnétique selon l'une des revendications précédentes.

12. Unité logique comportant une pluralité d'éléments logiques connectés en série ou en parallèle, chaque élément logique étant un dispositif magnétique selon l'une des revendications 1 à 10.

**13.** Procédé d'écriture d'une information dans la couche de stockage d'un dispositif selon l'une des revendications 1 à 10 **caractérisé en ce qu'**il comporte les étapes suivantes :

- application d'un champ de polarisation sans champ d'écriture tout en injectant un courant dans ledit dispositif de manière à chauffer ce dernier pour atteindre la température de blocage de ladite couche de piégeage ;
- une fois la température de blocage atteinte, application d'un couple magnétique d'écriture de manière à orienter l'aimantation de la couche de stockage selon l'une des deux directions stables d'aimantation.

**Patentansprüche**

**1.** Magnetische Vorrichtung (1, 100, 300, 400) zum thermisch unterstützten Schreiben, umfassend:

- eine erste magnetische Schicht, bezeichnet als Referenzschicht" (3);
- eine zweite magnetische Schicht, bezeichnet als "Lagerschicht" (5), die eine variable Magnetisierungsrichtung aufweist;
- einen Abstandshalter (4), der die Referenzschicht und die Lagerschicht trennt und sie magnetisch entkoppelt;
- eine anti-ferromagnetische Fixierungsschicht (14) in Kontakt mit der Lagerschicht, wobei die antiferromagnetische Schicht geeignet ist, die Magnetisierungsrichtung der Lagerschicht zu fixieren, wobei die genannte Lagerschicht wenigstens zwei Lagerschichten aufweist, die zwei stabilen, fixierten Magnetisierungsrichtungen entsprechen;
- Heizmittel (15) der genannten Fixierungsschicht (14) derart, dass beim Heizen die Temperatur der genannten Fixierungsschicht ihre Blockier-temperatur derart übersteigt, dass die Magnetisierungsrichtung der genannten Lagerschicht (5) nicht mehr fixiert ist;
- Mittel (16) zum Anwenden eines magnetischen Schreibmoments für die Fluchtung der Magnetisierung der Lagerschicht (5) gemäß einer der zwei stabilen Magnetisierungsrichtungen, sobald die genannte Blockier-temperatur erreicht ist;

wobei die genannte Vorrichtung (1) **dadurch gekennzeichnet ist, dass** sie Mittel (8, 101, 102, 200, 308, 409) zum Anwenden eines magnetischen Polarisationsfeldes wenigstens während der Heizphase vor dem Erreichen der Blockiertemperatur derart umfasst, dass die Magnetisierungsrichtung der genannten Lagerschicht (5) stets in der Richtung des genannten magnetischen Polarisationsfeldes ist, wenn sie die Blockiertemperatur erreicht.

**2.** Vorrichtung gemäß dem voranstehenden Anspruch, **dadurch gekennzeichnet, dass** die genannten Mittel (16) zum Anwenden eines magnetischen Schreibmoments Mittel zum Anwenden eines magnetischen Schreibfeldes zum Fluchten der Versorgung der Lagerschicht (5) gemäß einer der zwei stabilen Magnetisierungsrichtungen sind, sobald die genannte Blockiertemperatur erreicht ist.

**3.** Magnetische Vorrichtung gemäß dem voranstehenden Anspruch, **dadurch gekennzeichnet, dass** die Amplitude des Polarisationsfeldes zwischen 10 % und 120 % der Amplitude des Schreibfeldes und bevorzugt zwischen 25 % und 120 % der Amplitude des Schreibfeldes inbegriffen ist.

**4.** Magnetische Vorrichtung gemäß einem der voranstehenden Ansprüche, **dadurch gekennzeichnet, dass** die Richtung des genannten magnetischen Polarisationsfeldes unterschiedlich ist von denen der zwei stabilen, eingefangenen Magnetisierungsrichtungen.

**5.** Magnetische Vorrichtung gemäß dem voranstehenden Anspruch, **dadurch gekennzeichnet, dass** die Richtung des Polarisationsfeldes deutlich lotrecht zu den stabilen, fixierten Magnetisierungsrichtungen ist.

**6.** Magnetische Vorrichtung gemäß einem der voranstehenden Ansprüche, **dadurch gekennzeichnet, dass** die genannten Mittel zum Anwenden eines magnetischen Polarisationsfeldes durch eine harte ferromagnetische Materialschicht gebildet sind, die sich in der Nähe der genannten Lagerschicht befindet.

**7.** Magnetische Vorrichtung gemäß einem der voranstehenden Ansprüche 1 bis 5, **dadurch gekennzeichnet, dass** die genannten Mittel zum Anwenden eines magnetischen Polarisationsfeldes durch eine ferromagnetische Materialschicht gebildet sind, deren Magnetisierung durch eine antiferromagnetische Schicht fixiert ist und sich in der Nähe der genannten Lagerschicht befindet.

**8.** Magnetische Vorrichtung gemäß einem der Ansprüche 1 bis 5, **dadurch gekennzeichnet, dass** die genannten Mittel zum Anwenden eines magnetischen Polarisationsfeldes wenigstens während der voranstehenden Heizperiode vor dem Erreichen der Blockiertemperatur durch wenigstens eine natürliche oder künstliche ferrimagnetische Materialschichte gebildet sind, deren Magnetisierung deutlich ansteigt, wenn sich die Temperatur der genannten Blockiertemperatur annähert und zu einer niedrigeren Temperatur übergeht.

9. Magnetische Vorrichtung gemäß einem der Ansprüche 1 bis 5, **dadurch gekennzeichnet, dass** die genannten Mittel zum Anwenden eines magnetischen Polarisationsfeldes wenigstens während der Heizphase vor dem Erreichen der Blockiertemperatur durch eine leitende Leitung zum Erzeugen eines Feldes gebildet sind, in dem ein Strom zirkuliert.

10. Magnetische Vorrichtung gemäß einem der voranstehenden Ansprüche, **dadurch gekennzeichnet, dass** die magnetischen Lager- und Referenzschichten eine Magnetisierungsrichtung außerhalb der Ebene der genannten Schichten aufweisen, wobei das genannte magnetische Polarisationsfeld parallel zur Ebene der magnetischen Schichten ist.

11. Magnetspeicher, umfassend eine Vielzahl von Speicherpunkten, wobei jeder Speicherpunkt eine magnetische Vorrichtung gemäß einem der voranstehenden Ansprüche ist.

12. Logische Einheit, umfassend eine Vielzahl von in Serie oder parallel geschalteten logischen Elementen, wobei jedes logische Element eine magnetische Vorrichtung gemäß einem der Ansprüche 1 bis 10 ist.

13. Schreibverfahren einer Information in der Lagerschicht einer Vorrichtung gemäß einem der Ansprüche 1 bis 10, **dadurch gekennzeichnet, dass** sie die folgenden Schritte umfasst:

   - Anwenden eines Polarisationsfeldes ohne Schreibfeld bei gleichzeitigem Einschießen eines Stroms in die genannte Vorrichtung derart, dass diese erhitzt wird, um die Blockiertemperatur der genannten Fixierungsschicht zu erreichen;
   - nachdem die Blockiertemperatur erreicht ist, Anwenden eines magnetischen Schreibmoments derart, dass die Magnetisierung der Lagerschicht gemäß einer der zwei stabilen Magnetisierungsrichtungen erreicht wird.

## Claims

1. Magnetic device (1, 100, 300, 400) with thermally assisted switching comprising:

   - a first magnetic layer referred to as "reference layer" (3);
   - a second magnetic layer referred to as "storage layer" (5) that has a variable direction of magnetization;
   - a spacer (4) that separates the reference layer and the storage layer and magnetically decouples them;
   - an antiferromagnetic layer for pinning (14) in contact with the storage layer, with the antiferromagnetic layer being capable of pinning the direction of magnetization of the storage layer, said storage layer having at least two levels of storage corresponding to two stable pinned directions of magnetization;
   - means for heating (15) said pinning layer (14) in such a way that, during the heating, the temperature of said pinning layer exceeds its blocking temperature in such a way that the direction of magnetization of said storage layer (5) is no longer pinned;
   - means (16) for applying a magnetic writing torque that tends to align the magnetization of the storage layer (5) according to one of two stable directions of magnetization once said blocking temperature is reached;

   said device (1) being **characterised in that** it comprises means (8, 101, 102, 200, 308, 409) for applying, at least during the heating phase preceding the reaching of the blocking temperature, a magnetic polarization field in such a way that the direction of magnetization of said storage layer (5) is always in the direction of said magnetic polarization field at the moment the blocking temperature is reached.

2. Device as claimed in the preceding claim **characterised in that** said means (16) for applying a magnetic writing torque are means for applying a magnetic writing field that tends to align the magnetization of the storage layer (5) according to one of two stable directions of magnetization once said blocking temperature is reached.

3. Magnetic device as claimed in the preceding claim, **characterised in that** the amplitude of the polarization field is between 10% and 120% of the amplitude of the writing field and preferentially between 25% and 120% of the amplitude of the writing field.

4. Magnetic device according to one of the preceding claims **characterised in that** the direction of said magnetic polarization field is different from said two stable pinned directions of magnetization.

5. Magnetic device as claimed in the preceding claim **characterised in that** the direction of the polarization field is substantially perpendicular to the stable pinned directions of magnetization.

6. Magnetic device according to one of the preceding claims **characterised in that** said means for applying a magnetic polarization field are formed by a layer of hard ferromagnetic material located in the vicinity of said storage layer.

7. Magnetic device according to one of the preceding claims 1 to 5 **characterised in that** said means for applying a magnetic polarization field are formed by a layer of ferromagnetic material of which the magnetization is pinned by an antiferromagnetic layer and located in the vicinity of said storage layer.

8. Magnetic device according to one of claims 1 to 5 **characterised in that** said means for applying, at least during the heating phase preceding the reaching of the blocking temperature, a magnetic polarization field are formed by at least one layer of natural or artificial ferrimagnetic material of which the magnetization increases substantially when the temperature thereof approached said blocking temperature and decreases at a lower temperature.

9. Magnetic device according to one of claims 1 to 5, **characterised in that** said means for applying, at least during the heating phase preceding the reaching of the blocking temperature, a magnetic polarization field are formed by a field generating conductive line wherein a current circulates.

10. Magnetic device according to one of the preceding claims **characterised in that** the magnetic storage and reference layers have a direction of magnetization outside the plane of said layers, said magnetic polarization field being parallel to the plane of the magnetic layers.

11. Magnetic memory comprising a plurality of memory points, with each memory point being a magnetic device according to one of the preceding claims.

12. Logic unit comprising a plurality of logic elements connected in series or in parallel, with each logic element being a magnetic device according to one of claims 1 to 10.

13. Method for writing information in the storage layer of a device according to one of claims 1 to 10 **characterised in that** it comprises the following steps:

- application of a polarization field without writing field while still injecting a current into said device in such a way as to heat the latter in order to reach the blocking temperature of said pinning layer;
- once the blocking temperature is reached, application of a magnetic writing torque in such a way as to direct the magnetization of the storage layer according to one of the two stable directions of magnetization.

Fig. 1

1

8 7

**Fig. 2**

5

4

3

15

16

y

x

Ralentissement du chauffage lié à la rotation de
l'aimantation de la couche de stockage de AP à 90°C

Température de la
couche de stockage (°C)

200

Accélération du chauffage lié à la rotation de
l'aimantation de la couche de stockage de P à 90°C

150

100

50

5   10   15   20   25   30   35   Temps (ns)

**Fig. 3**

Fig. 4

**Fig. 5**

**Fig. 6**

**Fig. 7**

**Fig. 8**

**Fig. 9**

**Fig. 10**

**Fig. 11**

400A  405A  405B  400C  405C  405D

"0"  "0"  "0"  "1"

403A  400B  403B  403C  400D  403D

EP 2 685 458 B1

**EP 2 685 458 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2817999

- FR 2924851